Europäisches Patentamt

European Patent Office

Office européen des brevets

(19)

(11) Publication number: **0 249 060**
**A2**

## (12) EUROPEAN PATENT APPLICATION

(21) Application number: **87107231.0**

(22) Date of filing: **19.05.87**

(51) Int. Cl.⁴: **H03L 7/00**

(30) Priority: **13.06.86 US 873924**

(43) Date of publication of application:
**16.12.87 Bulletin 87/51**

(84) Designated Contracting States:
**DE FR GB**

(71) Applicant: **International Business Machines Corporation**
**Old Orchard Road**
**Armonk, N.Y. 10504(US)**

(72) Inventor: **RAE; James Wilson**
**5602 25th Avenue NW**
**Rochester Minnesota 55901(US)**
Inventor: **Swart, David Peter**
**R.R.1, Box 645**
**Pine Island Minnesota 55963(US)**

(74) Representative: **Vekemans, André**
**Compagnie IBM France Département de Propriété Intellectuelle**
**F-06610 La Gaude(FR)**

(54) **Self-adjusting single-shot for phase-locked oscillator.**

(57) A VCO-based circuit (100) locks the width of a generated pulse to the width of a clock pulse, even though the latter pulse occurs at a different time than the former. The circuit has a VCO (123), a latch (130) for input data pulses, pulse-delay means (150), and a pulse generator (140) whose width is controlled by a logical combination of signals from its own output, the VCO, and the delayed data pulses.

FIG. 1

EP 0 249 060 A2

## SELF-ADJUSTING SINGLE-SHOT FOR PHASE-LOCKED OSCILLATOR

The present invention relates to electronic circuits, and more particularly concerns a circuit for controlling the width of a signal pulse by an oscillator whose frequency and/or phase is controlled by an external signal.

Controlled oscillators, such as voltage-controlled oscillators and phase-locked oscillators, are frequently used to track the frequency and phase of signals in applications such as digital data recovery, display-scan generation, instrumentation, communications, and diverse other technological areas. The present embodiment was developed in connection with a data-read circuit for a magnetic disk.

Some applications in the above areas require generation of a pulse whose width must be proportioned closely to that of another signal, even though the two signals may occur at different times in a cycle of the oscillator signal. In the past, the width of the generated pulse has been manually set during manufacture or during service to a fixed nominal width, and then left constant. This requires that each and every unit be adjusted separately, and it makes no provision for changes during operation from variations in temperature, supply voltages, and many other factors. In the unit for which this circuit was developed, a mere 3% error in the pulse width can increase the data error rate by a factor of ten. The effects of mismatching will be explained in more detail in connection with the description of the preferred embodiment.

The present invention matches the width of a generated pulse to the width of another pulse, even though the latter pulse may occur at a different time, uncorrelated with the occurrence of the generated pulse. The widths are locked together automatically, in spite of environmental variations and other effects. Moreover, the pulse generator needs only to be set to a nominal width approximating its correct width, so that no adjustment of individual circuits is necessary.

Broadly speaking, a circuit according to the invention accomplishes these and other goals with a controlled oscillator (VCO) for producing clock pulses defining windows for a sequence of input pulses, a data latch for producing timed data pulses from the input pulses, a delay for shifting and standardizing the data pulses, and a pulse generator for producing control pulses whose width tracks that of the clock pulses. The pulse generator includes control means for altering the pulse width of a single-shot in response to a combination of the delayed data pulses, the clock pulses, and the control pulses themselves.

Fig. 1 is a diagram of a circuit according to the present invention.

Fig. 2 shows details of a conventional control circuit used in the circuit of Fig. 1.

Fig. 3 is a timing diagram for the circuit of Fig. 1.

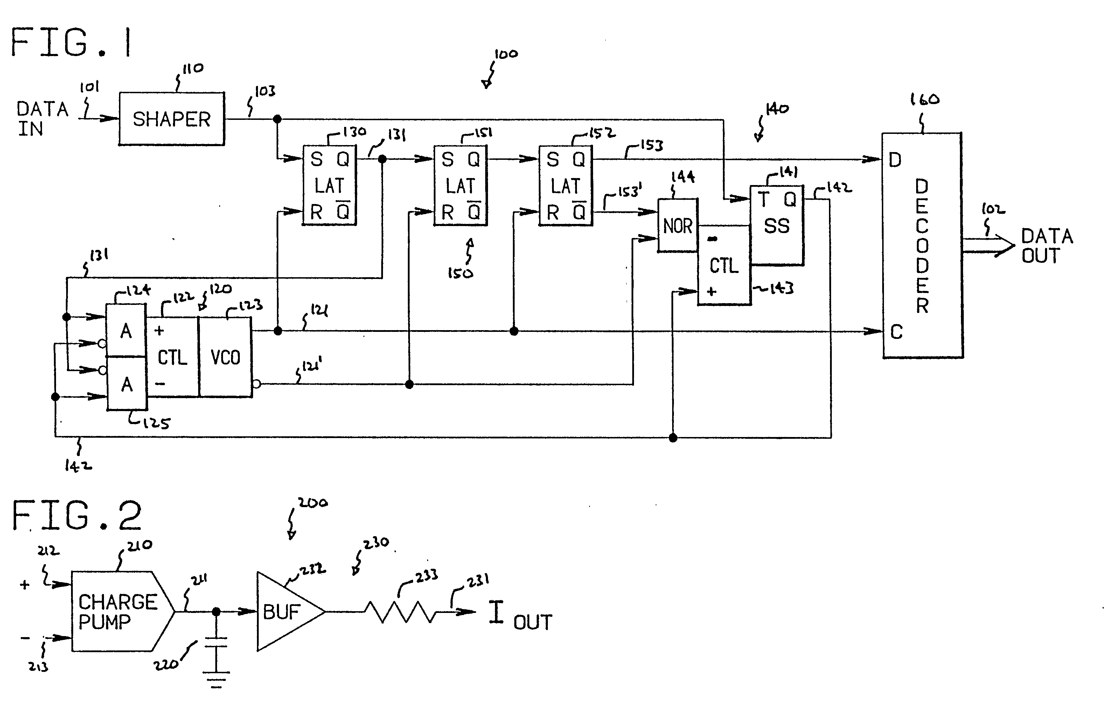

Fig. 1 shows a circuit 100 for recovering digital data from a magnetic disk or other source. The overall function of circuit 100 is to convert a serial analog DATA IN signal on line 101 to a digital DATA OUT signal on line 103. FIG. 3 shows timing waveforms 300 associated with the circuit.

Conventional pulse shaper 110 thresholds signals 101 to produce a waveform 310 having constant-width pulses 311. These pulses, however, may be early or late with respect to the center of a nominal data window or time interval 301. The legends in the intervals note whether the pulse is early, late, on time, or missing altogether in each window. (The particular code used in this example disallows pulses in immediately adjacent windows.)

A voltage-controlled oscillator (VCO) 120 produces a clock waveform 320 on line 121, and an inverted replica on line 121'. One cycle of wave 320 defines a window interval 301, and one of the transitions 321 defines its midpoint or on-time position. Control circuit 122 increases the frequency, and thus advances the phase, of square-wave oscillator 123 upon a signal from AND gate 124, and decreases its frequency, and thus retards the phase, in response to a signal from AND 125. VCOs such as 120 are also known as phase-locked oscillators.

Data latch 130 is set by data pulses 311 on line 103, as shown at transition 331 in waveform 330. Latch 130 is then reset at 332 by the next end-of-window transition 322 in VCO clock 320. Thus, the length of a data-latch pulse 333 varies according to the position of data pulse 311 within window 301.

Pulse generator 140 contains a single-shot 141 whose output 340 on line 142 contains pulses 341 whose position must track the position of data pulse 311, but whose width must remain as close as possible to that of one half cycle 323 of VCO clock 320. Maintaining this accurate duration, in spite of the inability to compare pulse transitions directly, is a primary object of the present invention. To this purpose, line 103 triggers single-shot 141, and the duration of pulse 341 is set by control circuit 143. NOR gate 144 increases the pulse duration, while an input on line 142 tends to decrease it.

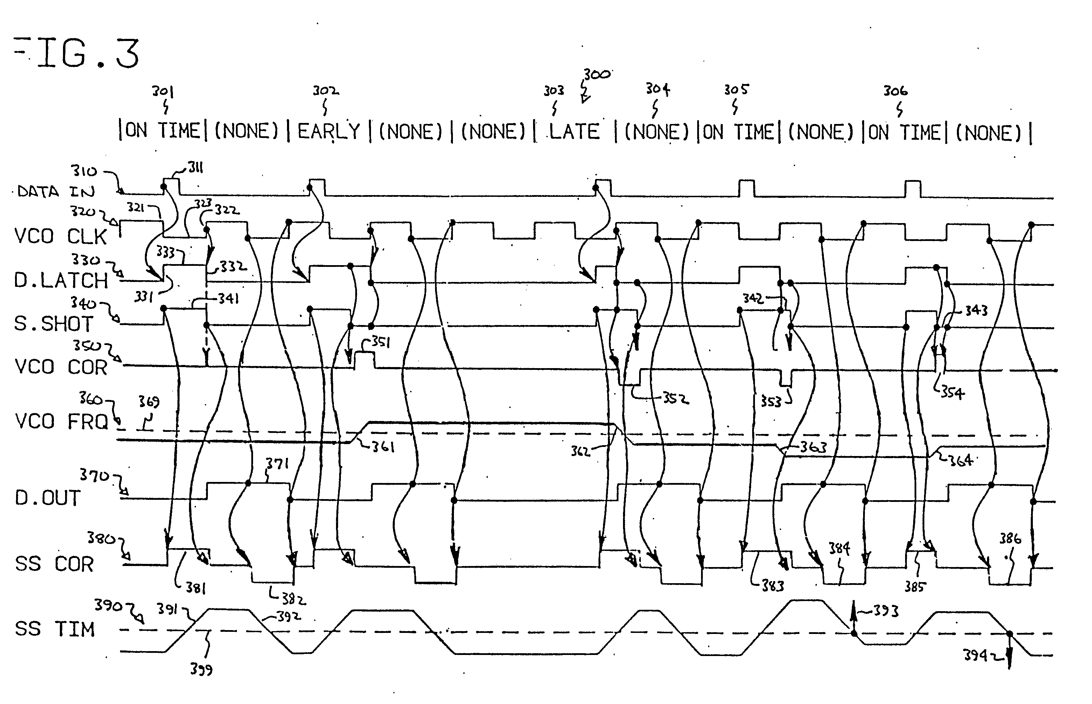

Fig. 2 shows an example of a conventional control circuit 200 which can be employed as circuits 122 and 143, Fig. 1. Charge pump 210 pushes charge into line 211 at a constant rate in response to a digital signal on "increase" line 212, and pulls charge out of line 211 in response to a signal on "decrease" line 213. This action increases and decreases the voltage of capacitor 220. Converter 230 changes the capacitor voltage to a current on output line 231. Buffer amplifier 232 presents a high impedance to avoid droop in the capacitor voltage, and resistor 233 converts the buffer output voltage to a current for controlling an external circuit. The parameters of circuit 200 can be set so that output 231 changes at any desired rate in response to changes in the input. Normally, this rate is sufficiently low that output 231 does not change any appreciable amount over a single cycle of the controlled waveform. Thus, both inputs 212 and 213 may be active at different times during a single cycle without producing large percentage changes in the circuit being controlled. For control circuit 143, the correction time is set so that many hundreds of cycles of signal 340 pass for any major change in the output current (about one disk revolution in the preferred environment). Control circuit 122 is set to react much more quickly, almost window-by-window. Circuit 122 may also include a resistor (not shown) in series with capacitor 220 to ensure overall stability of its loop.

Returning to Figs. 1 and 3, delay unit 150 delays data pulses from latch 130 for one window time, in order to differentiate between those windows having a late data pulse, and those having no pulse at all. Latch 151 is set by the output of data latch 130 on line 131, and is reset by the following positive transition on inverted VCO clock 121'. Latch 152 is then set by the output of latch 151, and is reset by the opposite phase of the VCO clock, on line 121. This effectively forms a shift register for delaying data pulses 333 by one window time. The output data pulses on line 153 (and the inverse pulses on line 153') are also lengthened and standardized to fill the entire window interval, whereas the data-latch pulses on line 131 are shorter and of variable width.

Conventional data decoder 160 converts the delayed data pulses to parallel bits on lines 102, by sensing the state of line 153 when VCO clock line 121 makes a positive transition, and accumulating the bits.

VCO 120 tracks the data pulses so as to maintain pulses 311 in the center of windows 301 in spite of variations in their overall speed and phase. AND 124 tends to increase the frequency of clock 320 during that part of a cycle when a data-latch signal 330 is high and single-shot signal 340 is low. AND 125 tends to decrease the clock frequency during that part of a cycle when the opposite condition obtains.

Waveform 350 illustrates the correction signals on inputs 212 and 213 (for clarity, a positive pulse indicates a pulse at input 212, while a negative pulse in wave 350 indicates a pulse at input 213). Waveform 360 illustrates, to a greatly exaggerated scale, the resulting correction signal from output 231. Dashed line 369 indicates a nominal baseline value. During window 301, data pulse 311 is on time, so pulses 333 and 341 exactly coincide, and no correction occurs. The window designated 302 shows an early data pulse and its resulting correction 351. This increases the frequency of clock 320 very slightly at 361. Window 303 has a late data pulse, which generates an opposite correction 352, and decreases the VCO clock frequency very slightly at 362. During windows such as 304 where no data pulse is present, no correction occurs, because neither latch 130 nor pulse generator 140 is triggered by line 103.

Windows 305 and 306 illustrate the effects of errors in the pulse width of single-shot 141. Because the single-shot pulse in window 305 is longer than the VCO clock pulse, the overhang portion 342 produces a spurious correction pulse 353, incorrectly changing the VCO frequency at 363, even though the data pulse is exactly on time. The opposite effect occurs in window 306; the missing portion 343 of the single-shot pulse causes a false correction at 354 and an improper frequency change at 364.

To eliminate this problem, control circuit 143 adjusts the width of the single-shot pulses in response to the width of the VCO clock pulses, even though they do not occur at the same time. Waveform 370 shows the output data signal on line 153; the signal on line 153' is the inverse of this wave. Waveform 380 shows the output 211 of control 143, while waveform 390 shows, at a greatly exaggerated scale, the output 231 for controlling the pulse width of single-shot 141; dashed line 399 shows a nominal baseline for the normal width of pulses 341. First, the single-shot output 142 itself returns to the "decrease" input of control 143. This produces a correction 381 tending to shorten the width of the pulses 341 via level change 391 (increasing Iout shorter the pulse). The "negative" input of control 143 produces a correction 382 tending to lengthen the width of pulses 341 when both data line 153' is down (i.e., when 153 is up) at 371 and inverse VCO clock 121' is down (check these polarities! One of them seems to be wrong). This correction appears as a level change at 392. No changes occur for windows which have no data pulses (note that the corrections occur partially in the window following the data pulse). The corrections hover around the nominal baseline value 399 as long as the single-shot pulses 341 have the correct width. The time-constant parameters of control 143 are set so that a large number --several hundred in the preferred embodiment --of windows are required to alter the pulse width 341 by a significant amount. Thus, the short-term variations about the nominal value have no net effect in windows 301-304.

However, when the single-shot pulse width becomes too great, as in window 305, the positive correction 383 exceeds the negative correction 384, and the signal 390 trends upward as indicated at 393. This tends to shorten the single-shot pulse width. Conversely, a short pulse causes the positive correction 385 to be shorter than the negative correction 386, causing the signal 390 to trend back downward at 394. This tends to lengthen the single-shot pulse width. The undesirable factors affecting the width of the single-shot pulses are environmental, drifting slowly over intervals of minutes. Therefore, the corrections can be made slowly as well. At typical data rates, the width of the single-shot pulses can be corrected in milliseconds. Thus, this circuit can eliminate inaccuracies from environmental and long-term component drifts without any manual adjustments whatever.

## Claims

1. A circuit for tracking a source of input pulses occurring in a sequence of windows, characterized in that it comprises:

a controlled oscillator (123) for producing clock pulses defining said windows in response to control pulses and data pulses;

a data latch (130) responsive to said input pulses and to said clock pulses for producing said data pulses;

delay means (150) for shifting said data pulses to a later time;

a pulse generator (140) for producing said control pulses having a duration related to the duration of said clock pulses, said pulse generator including

control means (143) responsive to said delay means, said clock pulses and to said control pulses for producing a correction signal,

a single-shot (141) for producing said control pulses having a width responsive to said correction signal.

2. A circuit according to Claim 1, characterized in that the time constant for appreciable change in the width of said control pulse is very large compared to the width of said control pulse.

3. A circuit according to Claim 1 or 2, characterized in that said control means is responsive to said control pulses to decrease the width of said correction pulses with increasing width of said control pulses.

4. A circuit according to Claim 3, characterized in that said control means includes logic responsive to a predetermined combination of said clock pulses and said data pulses to increase the width of said correction pulses.

5. A circuit according to anyone of Claims 1-4, characterized in that said delay means delays the beginning of said data pulses to one of said windows following that one of said windows in which it had originally begun.

6. A circuit according to Claim 5, characterized in that said delay means is further adapted to standardize the width of all said data pulses to a single value.

7. A circuit according to anyone of Claims 1-6, characterized in that said controlled oscillator is adapted to increase the frequency of said clock pulses for a first combination of said data pulses and said control pulses, and to decrease the frequency of said clock pulses for a second combination of said data pulses and said clock pulses.

8. A circuit according to Claim 7, characterized in that one of said first and second combinations occurs when said data pulses are on while said control pulses are off, and wherein the other of said combinations occurs when said data pulses are off while said control pulses are on.

9. A method for locking the width of a control pulse to the width of a reference clock pulse for a wave cycle in which said control pulse need have no transition simultaneous with a transition of said clock pulse, characterized in that it comprises:

generating a sequence of said clock pulses;

initiating a data pulse and said control pulse in response to an input pulse;

generating a first correction signal tending to decrease the width of said control pulse from said control pulse itself;

generating a second correction signal tending to increase the width of said control pulse from a function of said clock pulse and said data pulse.

10. A method according to Claim 9, characterized in that said function of said clock pulse and said data pulse includes delaying said data pulse.

# FIG.1

DATA IN 101 → SHAPER 110 → 103

100

SHAPER output 103 → S Q LAT R Q̄ (130) → 131 → S Q LAT R Q̄ (151) → S Q LAT R Q̄ (152) → 153

150

153' → NOR (144) — CTL + (143) → T Q SS (141) → 142

140

DECODER (160) D ... C → DATA OUT 102

131

A (124) / A (125) CTL + − (122) 120 / VCO (123) → 121 / 121'

131 ... 142

0 249 060

# FIG.2

212 + → CHARGE PUMP (210) → 211 → BUF (232) 230 → 233 → I OUT 231

213 − 

220

# FIG.3

| 301 | 302 | 303 | 304 | 305 | 306 |
| --- | --- | --- | --- | --- | --- |

| ON TIME | (NONE) | EARLY | (NONE) | (NONE) | LATE | (NONE) | ON TIME | (NONE) | ON TIME | (NONE) |

DATA IN

VCO CLK

D.LATCH

S.SHOT

VCO COR

VCO FRQ

D.OUT

SS COR

SS TIM

0 249 060